# EUROPEAN PATENT APPLICATION

(11) **EP 4 656 777 A1**
(43) Date of publication of application: **03.12.2025**
(21) Application number: 24778256.8
(22) Date of filing: 29.03.2024
(51) Int. Cl.: C30B 25/00, C30B 29/36

(54) **GRAPHITE RING, PREPARATION METHOD FOR SAME, AND EPITAXIAL DEVICE**

(30) Priority: 31.03.2023 CN 202310379545
(71) Applicant: Huawei Technologies Co., Ltd., Shenzhen, Guangdong 518129 (CN)
(72) Inventor: WANG, Peng, Shenzhen, Guangdong 518129 (CN); DUAN, Huantao, Shenzhen, Guangdong 518129 (CN); HU, Bin, Shenzhen, Guangdong 518129 (CN); LI, Wen, Shenzhen, Guangdong 518129 (CN)
(74) Representative: Gill Jennings & Every LLP
(86) International application number: PCT/CN2024/084914
(87) International publication number: WO 2024/199471

(57) **Abstract**

This application provides a graphite ring, a preparation method for the graphite ring, and an epitaxial device. The graphite ring may include a graphite matrix and a TaC layer. The graphite matrix has an annular structure, and the graphite matrix includes an upper surface, a lower surface, an inner wall of the matrix, and an outer wall of the matrix. The TaC layer covers the inner wall of the matrix. On the graphite matrix, a part or all of a surface other than the inner wall of the matrix is exposed, or a part or all of a surface other than the inner wall of the matrix is covered with a SiC layer. In the graphite ring provided in this application, the TaC layer covers the inner wall of the matrix, and the TaC layer can protect the inner wall of the matrix, to suppress the inner wall of the matrix from generating a falling object, so that the graphite ring has a long replacement interval. The TaC layer can further hinder deposition of SiC, so that the graphite ring has a long maintenance interval. According to the graphite ring provided in this application, on the graphite matrix, the part or all of the surface other than the inner wall of the matrix is exposed or covered with the SiC layer, so that the graphite ring has good heat dissipation performance.

## Description

This application claims priority to Chinese Patent Application No. 202310379545.7, filed with the China National Intellectual Property Administration on March 31, 2023 and entitled "GRAPHITE RING, PREPARATION METHOD FOR GRAPHITE RING, AND EPITAXIAL DEVICE", which is incorporated herein by reference in its entirety.

### TECHNICAL FIELD

This application relates to the field of silicon carbide crystal growth technologies, and in particular, to a graphite ring, a preparation method for the graphite ring, and an epitaxial device.

### BACKGROUND

A power semiconductor device, also referred to as a power electronic device (power electronic device), is a high-power electronic device used in an electric energy conversion and electric energy control circuit. The power semiconductor device needs to be designed and manufactured based on an epitaxial wafer, and includes a substrate and an epitaxial layer disposed on a surface of the substrate.

Usually, both the substrate and the epitaxial layer are made of a semiconductor material. Silicon carbide (SiC) is a typical semiconductor material. SiC has physical characteristics such as a wide bandgap, a high critical electric field strength, a high electron saturation drift velocity, and a high thermal conductivity. Therefore, SiC has a broad application prospect in the field of high-voltage, high-power, high-frequency, and high-temperature-resistant power semiconductor devices. A power semiconductor device with a SiC substrate/epitaxial layer is widely used in the fields of new energy vehicles, photovoltaic power generation, smart grids, and trams.

Generally, in a procedure of an epitaxial process, a graphite ring may be used to balance and adjust a temperature field, to form a uniform epitaxial layer on a surface of a substrate.

Currently, a disclosed graphite ring has a short replacement interval and maintenance interval, resulting in high consumption costs of the graphite ring.

### SUMMARY

This application provides a graphite ring, a preparation method for the graphite ring, and an epitaxial device. The graphite ring may include a graphite matrix and a TaC layer, and the TaC layer covers an inner wall of the graphite matrix. The TaC layer can suppress the inner wall of the matrix from generating a falling object, and can also suppress a decrease in an aperture of the graphite ring. The graphite ring has a long maintenance interval and replacement interval. In this way, the graphite ring has low consumption costs.

A first aspect of this application provides a graphite ring, used in a SiC epitaxial process. The graphite ring includes a graphite matrix and a TaC layer. The graphite matrix is an annular structural component, and a surface of the graphite matrix includes an annular upper surface, an annular lower surface, an inner wall that is of the matrix and that is enclosed between inner diameters of the upper surface and the lower surface, and an outer wall that is of the matrix and that is enclosed between outer diameters of the upper surface and the lower surface. The TaC layer covers the inner wall of the matrix. On the graphite matrix, at least a part of a surface other than the inner wall of the matrix is exposed or covered with a SiC layer.

In this implementation of this application, the TaC layer covers the inner wall of the matrix, and the TaC layer can protect the inner wall of the matrix, to suppress the inner wall of the matrix from generating a falling object, so that the graphite ring has a long replacement interval. The TaC layer can further hinder deposition of SiC, so that the graphite ring has a long maintenance interval. The graphite ring provided in this implementation has the long replacement interval and maintenance interval. Therefore, the graphite ring provided in this implementation has low consumption costs.

The graphite ring provided in this implementation has the long replacement interval and maintenance interval. When the graphite ring provided in this implementation is used in the epitaxial process, a problem of a sudden change in doping concentration of an epitaxial layer caused by replacement/maintenance of the graphite ring can be reduced, and difficulty in adjusting and controlling the doping concentration of the epitaxial layer in the epitaxial process is low.

In the graphite ring provided in this implementation, on the graphite matrix, at least the part of the surface other than the inner wall of the matrix is exposed or covered with the SiC layer. Compared with a graphite ring in which all of a surface of a graphite matrix is covered with a TaC layer, the graphite ring provided in this implementation has better heat dissipation performance.

With reference to a first implementation of the first aspect, the TaC layer further covers a first region of the upper surface, and the first region of the upper surface is a region bordering the inner wall of the matrix; and/or the TaC layer further covers a first region of the lower surface, and the first region of the lower surface is a region bordering the inner wall of the matrix.

In this implementation, the TaC layers covering the first region (including the first region of the upper surface and/or the first region of the lower surface) are disposed between the inner wall of the matrix and the exposed graphite matrix, to prevent a SiC crystal deposited on a surface of the exposed graphite matrix from extending in a direction of the inner wall of the matrix, and further alleviate a decrease in an aperture of the graphite ring, so that the graphite ring has a long maintenance interval.

In the graphite ring provided in this implementation, the outer wall of the matrix and a part/all of the upper surface/lower surface are exposed. Compared with a graphite ring in which all of a surface of a graphite matrix is covered with a TaC layer, the graphite ring provided in this implementation has better heat dissipation performance.

With reference to a second implementation of the first aspect, the SiC layer covers the outer wall of the matrix.

In this implementation, the SiC layer covers the outer wall of the matrix, and the SiC layer can suppress the outer wall of the matrix from generating a falling object, so that the graphite ring has a long replacement interval. Compared with a graphite ring in which all of a surface of a graphite matrix is covered with a TaC layer, the graphite ring provided in this implementation has better heat dissipation performance.

With reference to a third implementation of the first aspect, the SiC layer further covers a second region of the upper surface, and the second region of the upper surface is a region bordering the outer wall of the matrix; and/or the SiC layer further covers a second region of the lower surface, and the second region of the lower surface is a region bordering the outer wall of the matrix.

In this implementation, the SiC layer covers the second region of the upper surface and/or the second region of the lower surface, and the SiC layer can suppress the second region of the upper surface and/or the second region of the lower surface from generating a falling object, so that the graphite ring has a long replacement interval.

Compared with a graphite ring in which all of a surface of a graphite matrix is covered with a TaC layer, the graphite ring provided in this implementation has better heat dissipation performance.

With reference to a fourth implementation of the first aspect, a thickness of the TaC layer ranges from 0.1 µm to 1000 µm.

With reference to a fifth implementation of the first aspect, a thickness of the SiC layer ranges from 0.1 µm to 1000 µm.

With reference to a sixth implementation of the first aspect, the inner wall of the matrix includes at least one annular surface sequentially connected between the upper surface and the lower surface.

In this implementation, the annular surface may be flexibly configured based on a requirement, to flexibly configure a shape of a region limited by the inner wall of the matrix.

With reference to a seventh implementation of the first aspect, the at least one annular surface includes a first flow guiding surface, a limiting surface, and a second flow guiding surface. The first flow guiding surface is obliquely disposed, and the second flow guiding surface is obliquely disposed.

In this implementation, each of the first flow guiding surface and the second flow guiding surface has a flow guiding function, so that the graphite ring can have a function of adjusting and stabilizing a flow field. The graphite ring provided in this implementation is used in the epitaxial process. Because the graphite ring has the function of adjusting and stabilizing the flow field, a carbon source gas and a silicon source gas can evenly flow through a surface of a substrate, and finally, a uniform epitaxial layer can be formed on the surface of the substrate.

With reference to an eighth implementation of the first aspect, on the graphite matrix, all of the surface other than the inner wall of the matrix is exposed.

Compared with a graphite ring in which all of a surface of a graphite matrix is covered with a TaC layer, the graphite ring provided in this implementation has better heat dissipation performance.

With reference to a ninth implementation of the first aspect, on the graphite matrix, all of the surface other than the inner wall of the matrix is covered with the SiC layer.

Compared with a graphite ring in which all of a surface of a graphite matrix is covered with a TaC layer, the graphite ring provided in this implementation has better heat dissipation performance.

According to a second aspect of this application, a preparation method for a graphite ring is provided. The method includes: placing a graphite matrix in a reaction chamber, where the graphite matrix includes an annular upper surface, an annular lower surface, an inner wall that is of the matrix and that is enclosed between inner diameters of the upper surface and the lower surface, and an outer wall that is of the matrix and that is enclosed between outer diameters of the upper surface and the lower surface; and forming a film layer. The film layer includes a TaC layer, or the film layer includes a TaC layer and a SiC layer, where the TaC layer covers the inner wall of the matrix, and on the graphite matrix, at least a part of a surface other than the inner wall of the matrix is exposed or covered with the SiC layer.

The graphite ring prepared by using the preparation method provided in this implementation may include the graphite matrix and the TaC layer. The TaC layer covers the inner wall of the matrix, and the TaC layer can protect the inner wall of the matrix, to suppress the inner wall of the matrix from generating a falling object, so that the graphite ring has a long replacement interval.

The TaC layer can hinder deposition of SiC. In an epitaxial process, an increase in a thickness of the TaC layer per unit time is small. Therefore, the graphite ring has a long maintenance interval.

The graphite ring prepared in this implementation has the long replacement interval and maintenance interval. Therefore, the graphite ring prepared in this implementation has low consumption costs. In addition, the graphite ring prepared in this implementation has the long replacement interval and maintenance interval. When the graphite ring provided in this implementation is used in the epitaxial process, a problem of a sudden change in doping concentration of an epitaxial layer caused by replacement/maintenance of the graphite ring in the epitaxial process can be reduced, and difficulty in adjusting and controlling the doping concentration of the epitaxial layer in the epitaxial process is low.

Compared with the graphite ring in which all of a surface of a graphite matrix is covered with a TaC layer, in the graphite ring prepared in this implementation, on the graphite matrix, at least the part of the surface other than the inner wall of the matrix is exposed or covered with the SiC layer. The graphite ring prepared in this implementation has better heat dissipation performance.

With reference to a first implementation of the second aspect, the step of forming the film layer includes: forming the SiC layer on the surface of the graphite matrix, where the surface of the graphite matrix includes the inner wall of the matrix, the outer wall of the matrix, the upper surface, and the lower surface; removing the SiC layer in a target region, where the target region includes the inner wall of the matrix, or the target region includes the inner wall of the matrix and a third region, where the third region includes a first region of the upper surface and/or a first region of the lower surface, and the first region is a region bordering the inner wall of the matrix; and forming the TaC layer in the target region.

With reference to a second implementation of the second aspect, the step of forming the film layer includes: forming the TaC layer on the surface of the graphite matrix, where the surface of the graphite matrix includes the inner wall of the matrix, the outer wall of the matrix, the upper surface, and the lower surface; and removing the TaC layer in a target region, where the target region includes the outer wall of the matrix, or the target region includes the outer wall of the matrix and a fourth region, where the fourth region includes a second region of the upper surface and/or a second region of the lower surface, and the second region is a region bordering the outer wall of the matrix.

With reference to a third implementation of the second aspect, after the step of removing the TaC layer in the target region, the preparation method further includes: forming the SiC layer, where the SiC layer covers the target region.

A third aspect of this application provides an epitaxial device, including an epitaxial reactor and the graphite ring provided in the first aspect. The graphite ring is disposed in the epitaxial reactor.

For effect of the third aspect, refer to effect that can be achieved in any one of the implementations of the first aspect.

### BRIEF DESCRIPTION OF DRAWINGS

FIG. 1A is a top view of a graphite ring;
FIG. 1B is a sectional view of a region A in FIG. 1A on an AA' plane;
FIG. 1C is a sectional view of a region A in FIG. 1A on an AA' plane;
FIG. 2 is an analysis graph showing proportions of consumption costs of graphite members;
FIG. 3 is a curve chart indicating that doping concentration of an epitaxial layer changes with time;
FIG. 4 is a top view of a graphite ring provided in a feasible embodiment;
FIG. 5 is a sectional view of a region A in FIG. 4 on an AA' plane;
FIG. 6A is a top view of a graphite ring provided in a feasible embodiment;
FIG. 6B is a sectional view of a region A in FIG. 6A on an AA' plane;
FIG. 7A is a top view of a graphite ring provided in a feasible embodiment;
FIG. 7B is a sectional view of a region A in FIG. 7A on an AA' plane;
FIG. 8A is a top view of a graphite ring provided in a feasible embodiment;
FIG. 8B is a sectional view of a region A in FIG. 8A on an AA' plane;
FIG. 9A is a top view of a graphite ring provided in a feasible embodiment;
FIG. 9B is a sectional view of a region A in FIG. 9A on an AA' plane;
FIG. 10A is a top view of a graphite matrix provided in a feasible implementation;
FIG. 10B is a sectional view of a region A of the graphite matrix provided in FIG. 10A on an AA' plane;
FIG. 10C is a sectional view of a region A of the graphite matrix provided in FIG. 10A on the AA' plane;
FIG. 10D is a sectional view of a region A of the graphite matrix provided in FIG. 10A on the AA' plane;
FIG. 10E is a sectional view of a region A of the graphite matrix provided in FIG. 10A on the AA' plane;
FIG. 10F is a sectional view of a region A of the graphite matrix provided in FIG. 10A on the AA' plane;
FIG. 11 is an assembly diagram of an epitaxial reactor and a graphite ring provided in a feasible implementation;
FIG. 12A is a top view of a graphite ring provided in a feasible embodiment;
FIG. 12B is a sectional view of a region A in FIG. 12A on an AA' plane;
FIG. 12C is a sectional view of a region A in FIG. 12A on an AA' plane;
FIG. 13 is a flowchart of a preparation method for a graphite ring provided in a feasible embodiment;
FIG. 14A is a flowchart of a preparation method for a graphite ring provided in a feasible embodiment;
FIG. 14B is a process flowchart corresponding to the preparation method provided in FIG. 14A;
FIG. 15A is a flowchart of a preparation method for a graphite ring provided in a feasible embodiment; and
FIG. 15B is a process flowchart corresponding to the preparation method provided in FIG. 15A.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

The following terms "first", "second", and the like are merely used to distinguish between same items or similar items with basically the same functions and functions for a purpose of description, and cannot be understood as an indication or implication of relative importance or an implicit indication of a quantity of indicated technical features. Therefore, a characteristic limited by "first", "second", or the like may explicitly or implicitly include one or more characteristics.

In addition, in the descriptions of this application, "a plurality of" means two or more than two unless otherwise specified.

In addition, in this application, orientation terms such as "up", "down", "left", "right", "horizontal", and "vertical" are defined relative to orientations in which components are schematically placed in the accompanying drawings. It should be understood that, these directional terms are relative concepts that are used for relative description and clarification, and may vary accordingly based on changes of the orientations in which the components are placed in the accompanying drawings. Unless otherwise expressly specified and limited, the term "connection" should be understood in a broad sense. For example, the "connection" may be a fixed connection, a detachable connection, or an integrated connection, or may be a direct connection or an indirect connection implemented through an intermediate medium.

In addition, in embodiments of this application, the word such as "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word such as "example" or "for example" is intended to present a related concept in a specific manner for ease of understanding.

A power conversion module is an electric energy supply apparatus that converts a direct current into an alternating current and can supply the alternating current. The power conversion module may be directly installed on a printed circuit board (printed circuit board, PCB), to supply electric energy to an integrated circuit (application-specific integrated circuit, ASIC), a digital signal processor (digital signal processor, DSP), a microprocessor, a memory, and a field programmable gate array (field programmable gate array, FPGA). The power conversion module is widely used in the field of new energy vehicles, photovoltaic power generation, smart grids, and trams.

Generally, the power conversion module may include a busbar (busbar) through which a current flows and a power semiconductor device.

The busbar, also be referred to as a laminated busbar, is an electrical connection component with a multilayer laminated structure for a power module, and may be connected to power distribution locations of a plurality of circuits.

The power semiconductor device, also referred to as a power electronic device (power electronic device), is a high-power electronic device used in an electric energy conversion and electric energy control circuit. Generally, the power semiconductor device is made of a semiconductor material, and has two operating characteristics: conduction and cut-off.

For example, a Schottky diode (Schottky barrier diode, SBD) and a metal-oxide-semiconductor field-effect transistor (metal-oxide-semiconductor field-effect transistor, MOSFET) are two typical power semiconductor devices.

The SBD includes a substrate, and an anode and a cathode that are disposed on the substrate. The anode is made of a precious metal, and the cathode is made of an N-type semiconductor material. A contact surface between a positive electrode and a negative electrode may form a Schottky barrier layer. When a forward bias voltage is applied to two ends of the Schottky barrier layer (the anode is connected to a positive electrode of a power supply, and the cathode is connected to a negative electrode of the power supply), the Schottky barrier layer is narrowed, and internal resistance of the SBD is reduced. When the internal resistance of the SBD is reduced to a specific extent, the SBD is in a conducted state. When a reverse bias voltage is applied to two ends of a Schottky barrier layer, the Schottky barrier layer is widened, and internal resistance of the SBD is increased. When the internal resistance of the SBD is increased to a specific extent, the SBD is in a cut-off state. The N-type semiconductor material is defined as a semiconductor material having a large quantity of electrons.

The MOSFET includes a substrate, and a gate, a source, and a drain that are disposed on the substrate. The substrate is made of a P-type semiconductor material, two N-type regions are formed on the substrate, and a PN junction (PN junction) may be formed between the N-type region and the substrate. Then, the source connected to one of the N-type regions and the drain connected to the other N-type region are formed. There is a channel between the source and the gate, and the gate is located between the source and the gate, and above the channel. When no voltage is applied to the gate, the source is disconnected from the gate, that is, the MOSFET is in a cut-off state. When the voltage applied to the gate is greater than a threshold voltage, the source is connected to the gate. In other words, the MOSFET is in a conducted state. The P-type semiconductor material is defined as a semiconductor material having a large quantity of holes.

The power semiconductor device includes a substrate. The substrate is a wafer having a specific crystal plane and appropriate electrical, optical, and mechanical characteristics.

During growth of crystal, a defect is inevitably present on a surface of the substrate. If another component (for example, an electrode) is directly disposed on the substrate, quality of the entire substrate is affected, resulting in adverse impact on performance of the power semiconductor device.

An epitaxial layer (Epitaxial layer) is formed on the surface of the substrate, so that the surface of the substrate can be flatter, and the defect on the surface of the substrate can be compensated for, to ensure that the power semiconductor device has excellent performance.

For example, the MOSFET includes a heavily doped substrate, and a lightly doped epitaxial layer is formed on the heavily doped substrate, to increase a breakdown voltage (breakdown voltage, BV) of a PN junction. The breakdown voltage of the PN junction is defined as a voltage corresponding to critical breakdown of the PN junction. A higher BV value indicates better reliability of the MOSFET. Heavy doping is defined as adding a large quantity of dopants to a semiconductor material, and light doping is defined as adding a large quantity of dopants to a semiconductor material.

Usually, both the substrate and the epitaxial layer are made of a semiconductor material. Silicon carbide (silicon carbide SiC) is a typical semiconductor material. SiC has physical characteristics such as a wide bandgap, a high critical electric field strength, a high electron saturation drift velocity, and a high thermal conductivity. Therefore, SiC has a broad application prospect in the field of high-voltage, high-power, high-frequency, and high-temperature-resistant power semiconductor devices. A power semiconductor device with a SiC substrate/epitaxial layer is widely used in the fields of new energy vehicles, photovoltaic power generation, smart grids, and trams.

In embodiments of this application, the power semiconductor device with the SiC substrate/epitaxial layer may be referred to as a SiC electronic power device.

The SiC power electronic device has high manufacturing costs. The high manufacturing costs are a major obstacle to further increase a penetration rate of the SiC power electronic device in various fields.

More than 60% of the manufacturing costs of the SiC power electronic device come from the SiC substrate and the SiC epitaxial layer. The SiC substrate is defined as a substrate prepared from SiC, and the SiC epitaxial layer is defined as an epitaxial layer prepared from SiC. In subsequent embodiments, unless otherwise specified, the substrate is the SiC substrate, and the epitaxial layer is the SiC epitaxial layer.

Therefore, continuously optimizing a production and manufacturing process to reduce production costs of the SiC substrate and the SiC epitaxial layer is a key factor for improving market competitiveness of the SiC power electronic device.

Currently, a preparation method for the SiC substrate includes a liquid phase epitaxy (liquid phase epitaxy, LPE) method, a chemical vapor deposition (chemical vapor deposition, CVD) method, a physical vapor transport (physical vapor transport, PVT) method, a high-temperature sintering method, a plasma spraying (plasma spraying) method, and the like.

A preparation method for the SiC epitaxial layer includes the LPE method, the CVD method, the PVT method, the high-temperature sintering method, and the plasma spraying method. A process of forming an epitaxial layer may be referred to as an epitaxial process. A mainstream epitaxial process in the industry is the CVD method.

Generally, the epitaxial process is completed by an epitaxial device. The epitaxial device may include an epitaxial reactor. The epitaxial reactor may be classified by structure into a horizontal hot-wall single-wafer epitaxial reactor, a planetary epitaxial reactor, a vertical-chamber epitaxial reactor, and a vertical-chamber epitaxial reactor. The horizontal hot-wall single-wafer epitaxial reactor dominates in the epitaxial industry in China due to its stable structure, simple operation, and mature and stable process.

A core component of a reaction chamber of the epitaxial reactor is a graphite member, and the graphite member retains original chemical acid resistance, corrosion resistance, and physical properties of graphite. In addition to providing physical support for growth of an epitaxial material, the graphite member also provides a temperature field and an flow field that are required for epitaxial layer growth, to provide a reaction place for the epitaxial process.

The epitaxial process needs to be performed in a high-temperature environment. In a feasible implementation, the epitaxial reactor may be heated through an intermediate-frequency coil, so that the epitaxial reactor can provide a temperature required for forming the epitaxial process.

Specifically, a heating procedure may be as follows: The intermediate-frequency coil is sleeved on a periphery of the epitaxial reactor, and the intermediate-frequency coil is connected to a power supply. The power supply may provide an alternating current for the intermediate-frequency coil. The alternating current flowing through the intermediate-frequency coil may generate an alternating magnetic field, the alternating magnetic field may generate an eddy current (eddy current), the eddy current may generate heat energy, and the heat energy may heat the epitaxial reactor. Heating through the intermediate-frequency coil may also be referred to as electromagnetic induction heating (induction heating).

Due to skin effect of induction heating, maximum current density of induction heating appears on a surface layer of a cross section of a heated body and attenuates to a center part according to a law of an exponential function. This phenomenon is referred to as the skin effect (skin effect).

Specifically, a surface of the epitaxial reactor releases a large amount of heat and has a high temperature, and a center part of the epitaxial reactor releases a small amount of heat and has a low temperature. As a result, there is a temperature field difference between different regions. The temperature field difference causes a non-uniform epitaxial layer formed on the surface of the substrate.

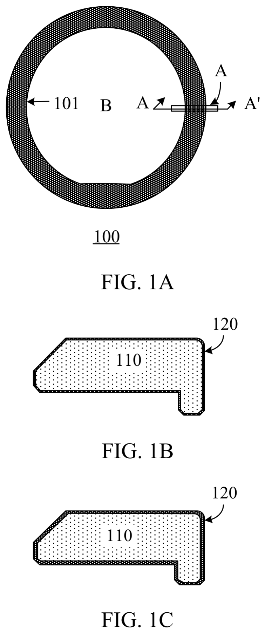

To form a uniform epitaxial layer on the surface of the substrate, the graphite member may further include a graphite ring. For a structure of the graphite ring, refer to FIG. 1A, FIG. 1B, and FIG. 1C. FIG. 1A is a top view of the graphite ring, FIG. 1B is a sectional view of a region A in FIG. 1A on an AA' plane, and FIG. 1C is a sectional view of a region A in FIG. 1A on an AA' plane. It can be seen that the graphite ring 100 is a component with an annular structure. In the epitaxial process, the substrate may be placed in a region B limited by an inner wall 101 of the graphite ring, and the graphite ring 100 may adjust and stabilize the temperature field, so that the uniform epitaxial layer can be formed on the surface of the substrate.

A procedure of the CVD epitaxial process may be as follows: The graphite ring is placed in the epitaxial reactor, and the substrate is placed in the region limited by the inner wall 101 of the graphite ring. Under effect of the intermediate-frequency coil, a temperature inside the epitaxial reactor is increased to 1500°C to 1700°C, so that the epitaxial reactor can provide a temperature required for the epitaxial layer. At an appropriate temperature, a carbon source gas and a silicon source gas are transported to the surface of the substrate by using hydrogen as a carrier gas. The carbon source gas and the silicon source gas are decomposed, diffused, adsorbed, migrated, and combined, to implement epitaxial layer growth of a SiC monocrystalline thin film material on the surface of the substrate. The carbon source gas is defined as a gas that can provide a carbon element, and the carbon element may include a carbon atom (C). The carbon source gas may include ethylene (C₂H₄), propane (C₃H₈), and the like. The silicon source gas is defined as a gas that can provide a silicon element, and the silicon element may include a silicon atom (Si). The silicon source gas may include silane (SiH₄), trichlorosilane (SiHCl₃), and the like.

In the epitaxial process, due to etching effect of the hydrogen carrier gas, each component of the graphite member may generate a falling object in the epitaxial process, and a common falling object is a graphite particle. Each component of the graphite member usually needs to be replaced after a specific epitaxial period, to ensure stability of the epitaxial process. Replacement intervals of different graphite members are greatly different due to different functions.

Among many graphite members, the graphite ring has a shortest replacement interval, and the graphite ring is a main consumption cost factor in epitaxial layer production.

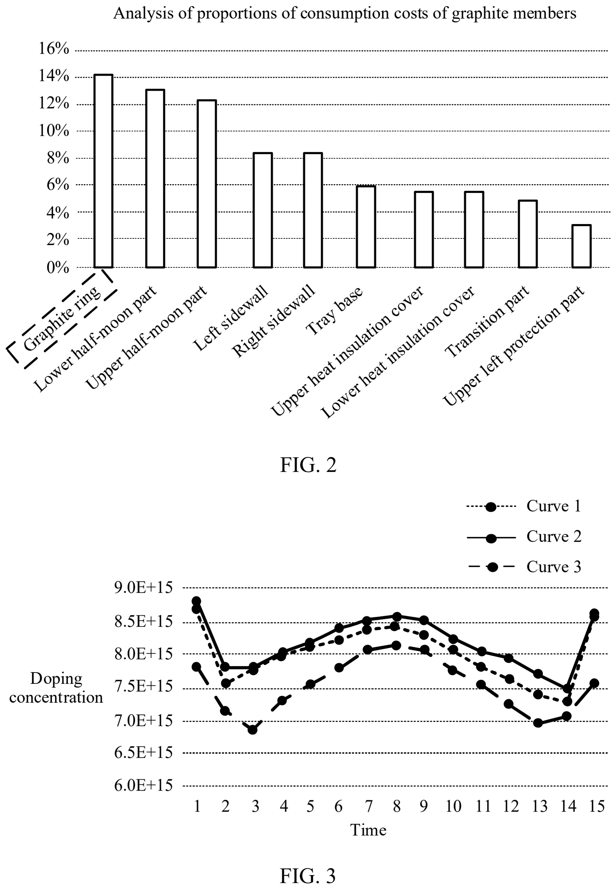

Refer to FIG. 2. FIG. 2 is an analysis graph showing proportions of consumption costs of graphite members. FIG. 2 shows several graphite members with high proportions of consumption costs, and the graphite members with high proportions of consumption costs may include a graphite ring, a lower half-moon part, an upper half-moon part, a left sidewall, a right sidewall, a tray base, an upper heat insulation cover, a lower heat insulation cover, a transition part, and an upper left protection part. Among the several graphite members provided in FIG. 2, the graphite ring has a highest proportion of consumption costs, which may reach about 14%. In this embodiment of this application, the proportion of consumption costs is defined as a ratio of consumption costs of one graphite member to consumption costs of all graphite members.

One of factors for the high proportion of consumption costs of the graphite ring is that a replacement interval of the graphite ring is short.

One of factors for the short replacement interval of the graphite member is that in an epitaxial process, the graphite ring may usually generate a falling object, and consequently, the graphite ring has the short replacement interval.

To alleviate the generation of the falling object from the graphite ring, in a feasible implementation, a graphite ring with a SiC layer disposed on a surface may be designed. For a structure of the graphite ring with the SiC layer disposed on the surface, refer to FIG. 1B. It may be seen that the graphite ring 100 may include a graphite matrix 110 and a SiC layer 120 disposed on a surface of the graphite matrix 110. The SiC layer 120 can suppress the graphite matrix 110 from generating the falling object, so that the graphite ring 100 can have a long replacement interval. A material used for the graphite matrix 110 includes graphite. A material used for the SiC layer 120 includes SiC.

In the epitaxial process, SiC generated through decomposition, diffusion, adsorption, migration, combination, and the like of the carbon source gas and the silicon source gas may be continuously deposited on a surface of the SiC layer 120, and consequently, the SiC layer 120 on the surface of the graphite matrix 110 continuously becomes thick.

For details, refer to FIG. 1B and FIG. 1C. FIG. 1B is a sectional view of the graphite ring before the epitaxial process starts. FIG. 1C is a sectional view of the graphite ring after the epitaxial process is performed for a period of time. It can be seen from comparison between FIG. 1B and FIG. 1C that the SiC layer 120 becomes thick after the epitaxial process is performed for the period of time.

As the SiC layer 120 becomes thick, an inner diameter of the graphite ring gradually decreases. For example, a region limited by the graphite ring is a circular region, and the inner diameter of the graphite ring is defined as a diameter of the region limited by the inner wall 101 of the graphite ring.

The decrease in the inner diameter of the graphite ring may cause a risk that the substrate placed in the region limited by the inner wall 101 of the graphite ring is detached from the graphite ring. Detaching the substrate from the graphite ring directly causes an epitaxial process failure.

To reduce the risk that the substrate is detached from the graphite ring, in an epitaxial production procedure in a related technology, at a specific frequency, the SiC layer 120 of the graphite ring is maintained or the graphite ring is replaced. A common maintenance manner is to polish the SiC layer 120.

For example, the SiC layer 120 of the graphite ring may be polished in the middle of each epitaxial period. The graphite ring may be replaced after one to two epitaxial periods.

For example, the SiC layer 120 may be polished at a time point at which an accumulated epitaxial thickness is 250 µm. The graphite ring may be replaced at a time point at which an accumulated epitaxial thickness is 500 µm.

Generally, a run-to-run control method is applied to the epitaxial process. In the run-to-run control method, based on forward supply and feedback of data, a manufacturing procedure and a device status are effectively monitored, and an offset of the manufacturing procedure is adjusted, to eliminate various types of interference to the manufacturing procedure, to increase a yield of the epitaxial layer. The supplied data may include a thickness of the graphite ring. The manufacturing procedure may include doping concentration in the epitaxial process.

Polishing/replacement of the graphite ring causes a sudden change in the thickness of the graphite ring, and correspondingly causes a sudden change in the doping concentration of the epitaxial layer, resulting in an increase in difficulty in adjusting the doping concentration. The sudden change is defined as that a change amount per unit time is greater than a specified value. For example, the sudden change in the thickness of the graphite ring may be considered as that the thickness of the graphite ring increases/decreases per unit time by a value greater than a specified value.

In the procedure of the epitaxial process, if the graphite ring provided with the SiC layer is used, as the epitaxial process proceeds, SiC is deposited on the surface of the graphite ring. As a result, the thickness of the graphite ring increases, and the graphite ring needs to be frequently polished/replaced, resulting in high consumption costs of the graphite ring.

Further, frequent polishing/replacement of the new graphite ring also causes a sudden change in a temperature field and a sudden change in a flow field in a run-to-run control procedure, resulting in a change of a rule for adjusting the doping concentration of the epitaxial layer, and further increasing difficulty in adjusting and controlling the doping concentration.

The following describes, with reference to specific accompanying drawings, impact of graphite ring replacement on the doping concentration of the epitaxial layer. Refer to FIG. 3. FIG. 3 shows curves indicating that the doping concentration of the epitaxial layer changes with time. FIG. 3 includes three curves in total. A curve 1 is a curve indicating that the doping concentration of the epitaxial layer changes with time in a first period. A curve 2 is a curve indicating that the doping concentration of the epitaxial layer changes with time in a second period. A curve 3 is a curve indicating that the doping concentration of the epitaxial layer changes with time in a third period. The first period, the second period, and the third period are consecutive, and the graphite ring is replaced in the third period. It can be seen that a sudden change in the doping concentration of the epitaxial layer in the third period is the largest, and the sudden change in the doping concentration of the epitaxial layer may be obtained based on a change amount of doping concentration of the epitaxial layer corresponding to time (3 to 8) in the figure.

In the procedure of the epitaxial process, if a graphite ring provided with no SiC layer is used, as the epitaxial process proceeds, graphite particles fall off the graphite ring. As a result, a replacement interval (a service life) of the graphite ring is short, and the graphite ring needs to be frequently replaced with a new graphite ring, resulting in high consumption costs of the graphite ring.

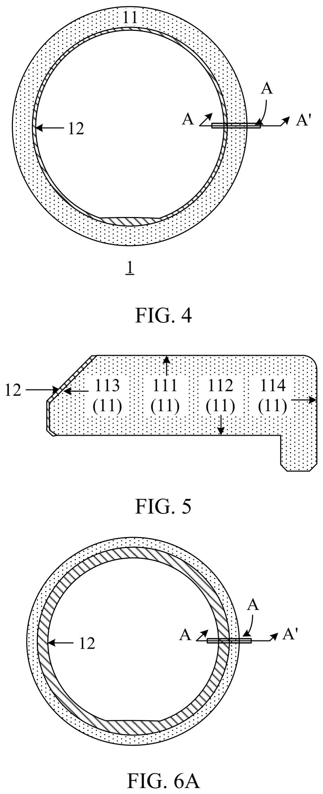

A currently disclosed graphite ring has a short maintenance interval and replacement interval, resulting in high consumption costs of the graphite ring, and high production costs of the epitaxial layer. To resolve the problems of the short maintenance interval and replacement interval and the high consumption costs of the currently disclosed graphite ring, an embodiment of this application provides a graphite ring. Refer to FIG. 4, FIG. 5, FIG. 6A, FIG. 6B, FIG. 7A, FIG. 7B, FIG. 8A, FIG. 8B, FIG. 9A, and FIG. 9B. It can be seen that a graphite ring 1 may include a graphite matrix 11 and a TaC layer 12. The graphite matrix 11 has an annular structure. The graphite matrix 11 includes an upper surface 111, a lower surface 112, an inner wall 113 that is of the matrix and that is enclosed between inner diameters of the upper surface 111 and the lower surface 112, and an outer wall 114 that is of the matrix and that is enclosed between outer diameters of the upper surface 111 and the lower surface 112. The TaC layer 12 covers the inner wall 113 of the matrix. On the graphite matrix, a part or all of a surface other than the inner wall 113 of the matrix is exposed or covered with a SiC layer 13.

In the graphite ring provided in this embodiment of this application, the TaC layer 12 covers the inner wall 113 of the matrix, and the TaC layer 12 can protect the inner wall 113 of the matrix, to suppress the inner wall 113 of the matrix from generating a falling object, so that the graphite ring 1 has a long replacement interval.

The TaC layer 12 can further hinder deposition of SiC. In an epitaxial process, an increase in a thickness of the TaC layer 12 per unit time is small. Therefore, the graphite ring 1 has a long maintenance interval.

The graphite ring 1 provided in this embodiment of this application has the long replacement interval and maintenance interval. Therefore, the graphite ring provided in this embodiment of this application has low consumption costs.

The graphite ring 1 provided in this embodiment of this application has the long replacement interval and maintenance interval. When the graphite ring provided in this embodiment of this application is used in the epitaxial process, a problem of a sudden change in doping concentration of an epitaxial layer caused by replacement/maintenance of the graphite ring can be reduced, and difficulty in adjusting and controlling the doping concentration of the epitaxial layer in the epitaxial process is low.

A thermal conductivity (thermal conductivity) is defined as heat transferred through an area of 1 square meter of a material with a thickness of 1 m under a stable heat transfer condition within a specified time period, where a temperature difference between surfaces of two sides of the material is 1 K. Heat dissipation performance of a material is related to a thermal conductivity of the material. A larger thermal conductivity of the material indicates better heat dissipation performance of a device prepared from the material. A smaller thermal conductivity of the material indicates poorer heat dissipation performance of a device prepared from the material.

A thermal conductivity of TaC is 22 W/(m.K), a thermal conductivity of graphite is 129 W/(m.K), and a thermal conductivity coefficient of SiC is 83 W/(m.K) . TaC has a low thermal conductivity, and correspondingly, a TaC layer prepared from TaC has poor heat dissipation performance. In the graphite ring, a larger area of the TaC layer indicates poorer heat dissipation performance of the graphite ring. In the graphite ring 1 provided in this embodiment of this application, on the graphite matrix, a part or all of the surface other than the inner wall 113 of the matrix is exposed, or a part or all of the surface other than the inner wall 113 of the matrix are covered with the SiC layer. Compared with a graphite ring in which all of a surface of a graphite matrix is covered with a TaC layer, the graphite ring provided in this embodiment of this application has better heat dissipation performance.

The following further describes components of the graphite ring 1 provided in this embodiment of this application.

The graphite ring 1 provided in this embodiment of this application may include the graphite matrix 11.

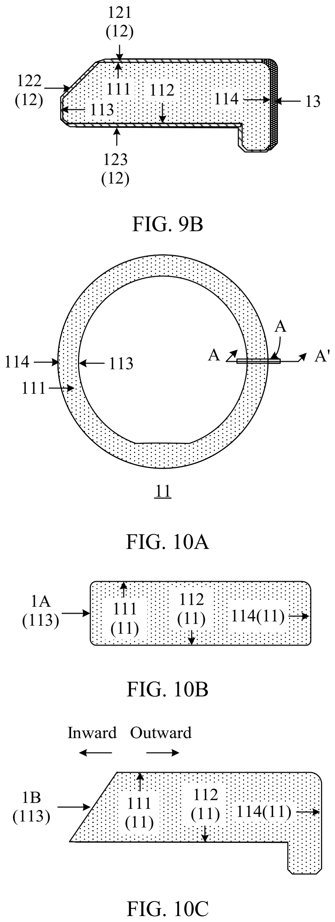

Refer to FIG. 10A. FIG. 10A is a top view of a graphite matrix provided in a feasible implementation. It can be seen that the graphite matrix 11 is an annular component. The graphite matrix 11 has an annular structure characteristic. In a process of heating through an intermediate-frequency coil, an eddy current may be generated around the graphite ring, and the eddy current around the graphite ring may interact with another eddy current in an epitaxial reactor, to stabilize a temperature field in the epitaxial reactor. It can be learned that the graphite matrix 11 can adjust and stabilize the temperature field.

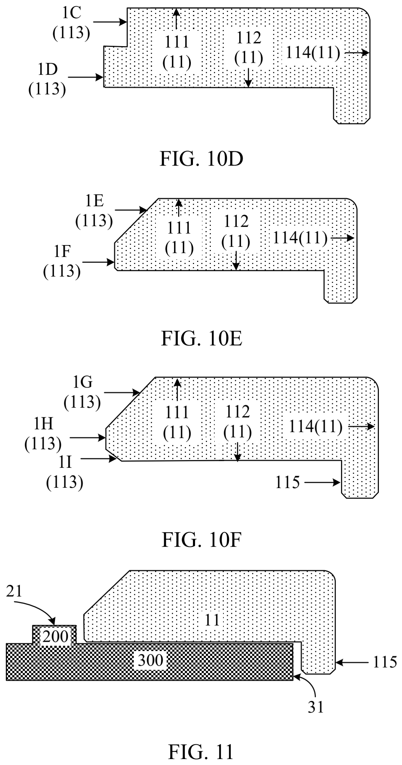

Refer to FIG. 10A, FIG. 10B, FIG. 10C, FIG. 10D, FIG. 10E, and FIG. 10F. It can be seen that the graphite matrix 11 includes the upper surface 111, the lower surface 112, the inner wall 113 that is of the matrix and that is enclosed between the inner diameters of the upper surface 111 and the lower surface 112, and the outer wall 114 that is of the matrix and that is enclosed between the outer diameters of the upper surface 111 and the lower surface 112. A structure of the inner wall 113 of the matrix is not specifically limited in embodiments of this application, and the structure of the inner wall 113 of the matrix may be disposed based on a requirement.

In this embodiment of this application, the inner wall 113 of the matrix is sequentially connected to at least one annular surface between the upper surface 111 and the lower surface 112.

In a feasible implementation, the inner wall 113 of the matrix may include one annular surface.

For example, refer to FIG. 10A and FIG. 10B. FIG. 10B is a sectional view of a region A of the graphite matrix provided in FIG. 10A on an AA' plane. It can be seen that the at least one annular surface may include a vertically disposed limiting surface 1A.

In an epitaxial process, the epitaxial reactor may include a tray for supporting a substrate. The graphite matrix 11 may be sleeved on a periphery of the tray. A height of the graphite matrix 11 is greater than a height of the tray. Therefore, the limiting surface 1A can limit the substrate placed on the tray, to limit sliding of the substrate.

For example, refer to FIG. 10A and FIG. 10C. FIG. 10C is a sectional view of a region A of the graphite matrix provided in FIG. 10A on an AA' plane. It can be seen that the at least one annular surface may include an obliquely disposed flow guiding surface 1B. The flow guiding surface 1B can adjust and stabilize a flow field, so that the graphite ring can have a function of adjusting and stabilizing the flow field.

It should be noted that FIG. 10C merely shows an example in which the flow guiding surface tilts inward from top to bottom. In an actual design procedure, the flow guiding surface tilts outward from top to bottom.

The graphite ring provided in this implementation is used in the epitaxial process. Because the graphite ring has the function of adjusting and stabilizing the flow field, a carbon source gas and a silicon source gas can evenly flow through a surface of the substrate, and finally, a uniform epitaxial layer can be formed on the surface of the substrate.

In a feasible implementation, the inner wall 113 of the matrix may alternatively include a plurality of annular surfaces. A specific quantity of annular surfaces may be set based on a requirement. This is not excessively limited in embodiments of this application.

For example, refer to FIG. 10A and FIG. 10D. FIG. 10D is a sectional view of a region A of the graphite matrix provided in FIG. 10A on an AA' plane. The plurality of annular surfaces may include a first limiting surface 1C and a second limiting surface 1D. The first limiting surface 1C is disposed on a top of the second limiting surface 1D, and an aperture (a first aperture) of a region limited by the first limiting surface 1C is greater than an aperture (a second aperture) of a region limited by the second limiting surface 1D.

In the epitaxial process, the tray for supporting the substrate may be placed in the region limited by the second limiting surface 1D. A size of the substrate is limited by a size of the second aperture. Because the first aperture is greater than the second aperture, a substrate with a large size may be placed on the tray.

For example, refer to FIG. 10A and FIG. 10E. FIG. 10E is a sectional view of a region A of the graphite matrix provided in FIG. 10A on an AA' plane. The plurality of annular surfaces may include a flow guiding surface 1E and a limiting surface 1F. The flow guiding surface 1E is disposed on a top of the limiting surface 1F.

For example, refer to FIG. 10A and FIG. 10F. FIG. 10F is a sectional view of a region A of the graphite matrix provided in FIG. 10A on an AA' plane. The plurality of annular surfaces may include a first flow guiding surface 1G, a limiting surface 1H, and a second flow guiding surface 1I. The first flow guiding surface 1G is disposed on a top of the limiting surface 1H, and the limiting surface 1H is disposed on a top of the second flow guiding surface 1I.

Still refer to FIG. 10F. To better fasten the graphite ring, in a feasible implementation, a bottom that is of the graphite matrix 11 and that is close to a periphery may further protrude downward to form a limiting protrusion 115.

Refer to FIG. 11. FIG. 11 is an assembly diagram of the epitaxial reactor and the graphite ring provided in a feasible implementation. It can be seen that the epitaxial reactor may include a tray 200 and a base 300. The tray 200 is placed on the base 300, and the tray 200 includes a bearing surface 21 for bearing the substrate.

The limiting protrusion 115 may be sleeved around an outer wall 31 of the base 300, so that the graphite ring 1 can be better fixed.

Embodiments of this application merely describe several structures of the graphite matrix as examples. The foregoing structures of the graphite matrix do not constitute a specific limitation. In an actual application process, the structure of the graphite matrix may be adjusted based on requirement, and the applicants make no excessive limitation herein.

A structure of the outer wall 114 of the matrix is not specifically limited in embodiments of this application. For example, the outer wall 114 of the matrix may be barrel-shaped.

A size of the graphite matrix is not specifically limited in embodiments of this application. The size of the graphite matrix 11 may include a size of an outer diameter of the graphite matrix 11, a size of an inner diameter of the graphite matrix 11, a thickness of the graphite matrix 11, and the like.

In a feasible implementation, the size of the inner diameter of the graphite matrix 11 may be designed based on a size of a substrate used in a subsequent epitaxial process, so that, in the epitaxial process, the substrate may be preferably placed in the region limited by the inner wall 113 of the matrix. For example, the size of the substrate may include 2 inches, 4 inches, 6 inches, 8 inches, and 10 inches.

In a feasible implementation, the size of the outer diameter of the graphite matrix 11 may be designed based on a size of an epitaxial reactor chamber, so that the graphite matrix can be preferably placed in the epitaxial reactor chamber. For example, the size of the epitaxial reactor chamber may include 2 inches, 4 inches, 6 inches, 8 inches, and 10 inches.

In a feasible implementation, the thickness of the graphite ring may be set based on the height of the tray in the epitaxial reactor. For example, the thickness of the graphite ring is preferably greater than the height of the tray.

The graphite ring 1 provided in this embodiment of this application further includes the tantalum carbide (tantalum carbide, TaC) layer 12.

The TaC layer 12 covers the inner wall 113 of the matrix. The TaC layer 12 can protect the inner wall 113 of the matrix, to suppress the inner wall 113 of the matrix from generating the falling object, so that the graphite ring has a long replacement interval. In addition, the TaC layer 12 can hinder deposition of SiC. In the graphite ring provided in this embodiment of this application, the inner wall of the matrix does not need to be polished at a specific frequency. Therefore, the graphite ring has a long maintenance interval. The graphite ring 1 provided in this embodiment of this application has the long replacement interval and maintenance interval. Therefore, the graphite ring provided in this embodiment of this application has low consumption costs.

Still refer to FIG. 4 and FIG. 5. FIG. 5 is a sectional view of a region A in FIG. 4 on an AA' plane. In a feasible implementation, the upper surface 111, the lower surface 112, and the outer wall 114 of the matrix may be exposed.

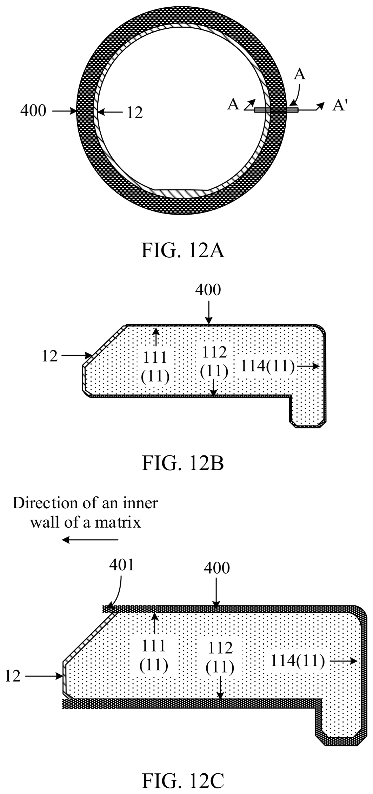

The graphite ring provided in this implementation is used in an epitaxial process. As the epitaxial process proceeds, a part of SiC is deposited on the surface (the upper surface 111, the lower surface 112, and the outer wall 114 of the matrix) of the exposed graphite matrix 11, to form a SiC crystal. In this case, for a structure of the graphite ring, refer to FIG. 12A and FIG. 12B. FIG. 12A is a top view of the graphite ring after the epitaxial process is performed for a period of time. FIG. 12B is a sectional view of a region A of the graphite ring 1 provided in FIG. 12A on an AA' plane. It can be seen that after the epitaxial process is performed for the period of time, the SiC crystal 400 covers the upper surface 111, the lower surface 112, and the outer wall 114 of the matrix. The SiC crystal 400 can prevent the upper surface 111, the lower surface 112, and the outer wall 114 of the matrix from generating a falling object. Therefore, the graphite ring provided in this implementation has a long replacement interval.

As the epitaxial process proceeds, the SiC crystal 400 gradually diffuses around. In this case, for a structure of the graphite ring, refer to FIG. 12C. FIG. 12C is a sectional view of a region A of the graphite ring provided in FIG. 12A on an AA' plane. It can be seen that the SiC crystal 401 that grows laterally may grow in a direction of the inner wall of the matrix, and consequently, an aperture of the graphite ring 1 is reduced, and the graphite ring 1 needs to be periodically polished and maintained. This shortens a maintenance interval of the graphite ring 1.

To make the graphite ring have a long maintenance interval, in a feasible implementation, the TaC layer may cover a first region of the upper surface and/or a first region of the lower surface. In this embodiment of this application, the first region is a region bordering the inner wall of the matrix.

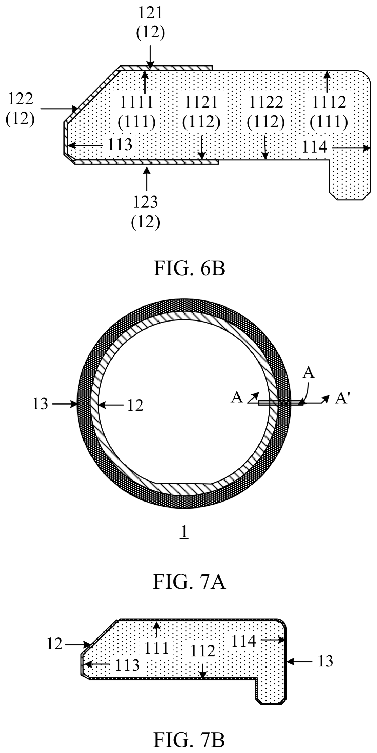

For details, refer to FIG. 6A and FIG. 6B. FIG. 6A is a top view of the graphite ring provided in a feasible embodiment, and FIG. 6B is a sectional view of a region A in FIG. 6A on an AA' plane. It can be seen that the TaC layer 12 includes a TaC layer 121 covering first 11 of the upper surface, a TaC layer 122 covering the inner wall 113 of the matrix, and a TaC layer 123 covering a first region 1121 of the lower surface. Other surfaces (1112, 1122, 114) of the graphite matrix are exposed.

It should be noted that FIG. 6A and FIG. 6B merely describe an example in which the TaC layer 12 covers the first region 1111 of the upper surface and the first region 1121 of the lower surface. In an actual application procedure, the TaC layer 12 may cover the first region 1111 of the upper surface and the inner wall 113 of the matrix, or the TaC layer 12 may cover the first region 1121 of the lower surface and the inner wall 113 of the matrix.

A size of the first region is not specifically limited in embodiments of this application, and the size of the first region may be set based on a requirement.

In this implementation, the TaC layers (121, 123) covering the first region (the first region 1111 of the upper surface and/or the first region 1121 of the lower surface) are disposed between the inner wall 113 of the matrix and the exposed graphite matrix, to prevent the SiC crystal deposited on a surface of the exposed graphite matrix from extending in a direction of the inner wall of the matrix, and further alleviate a decrease in the aperture of the graphite ring 1, so that the graphite ring 1 has a long maintenance interval.

In the graphite ring provided in this implementation, the outer wall of the matrix and a part/all of the upper surface/lower surface are exposed. Compared with a graphite ring in which all of a surface of a graphite matrix is covered with a TaC layer, the graphite ring provided in this implementation has better heat dissipation performance.

A thickness of the TaC layer 12 is not specifically limited in embodiments of this application, and the thickness of the TaC layer 12 may be set based on a requirement. For example, in a feasible implementation, the thickness of the TaC layer 12 may range from 0.1 µm to 1000 µm. For example, the thickness of the TaC layer 12 may be 0.1 µm, 1 µm, 10 µm, or 30 µm.

In some feasible implementations, the graphite ring 1 further includes the SiC layer 13.

For example, in this feasible implementation, the SiC layer may cover the upper surface, the lower surface, and the outer wall of the matrix. For details, refer to FIG. 7A and FIG. 7B. FIG. 7A is a top view of the graphite ring provided in a feasible embodiment, and FIG. 7B is a sectional view of a region A in FIG. 7A on an AA' plane. It can be seen that the TaC layer 12 covers the inner wall 113 of the matrix, and the TaC layer 12 suppresses the inner wall 113 of the matrix from generating a falling object. The SiC layer 13 covers the upper surface 111, the lower surface 112, and the outer wall 114 of the matrix, and the SiC layer 13 suppresses the upper surface 111, the lower surface 112, and the outer wall 114 of the matrix from generating a falling object.

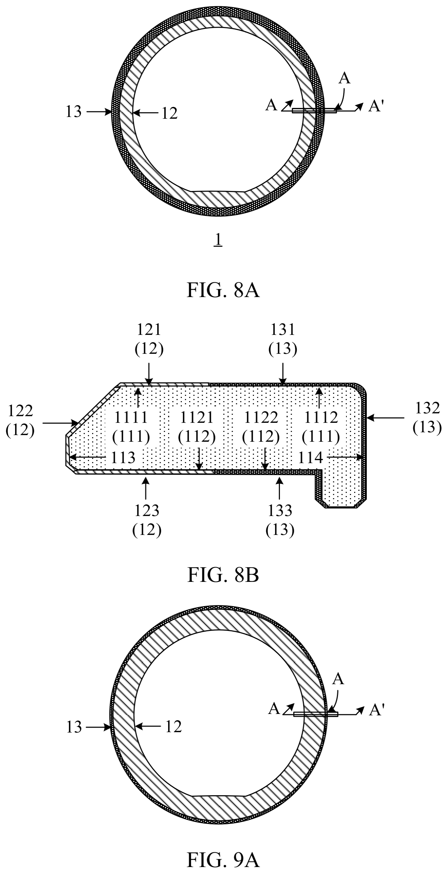

For example, in this feasible implementation, the SiC layer may cover a second region of the upper surface, a second region of the lower surface, and the outer wall of the matrix. For details, refer to FIG. 8A and FIG. 8B. FIG. 8A is a top view of the graphite ring provided in a feasible embodiment, and FIG. 8B is a sectional view of a region A in FIG. 8A on an AA' plane. It can be seen that the TaC layer 121 covers a first region 1111 of the upper surface, the TaC layer 122 covers the inner wall 113 of the matrix, the TaC layer 123 covers a first region 1121 of the lower surface, the SiC layer 131 covers a second region 1112 of the upper surface, the SiC layer 132 covers the outer wall 114 of the matrix, and the TaC layer 123 covers a second region 1122 of the lower surface. The second region is a region bordering the outer wall 114 of the matrix.

For example, in this feasible implementation, the SiC layer may cover the outer wall of the matrix. For details, refer to FIG. 9A and FIG. 9B. FIG. 9A is a top view of the graphite ring provided in a feasible embodiment, and FIG. 9B is a sectional view of a region A in FIG. 9A on an AA' plane. It can be seen that the TaC layer 121 covers the upper surface 111, the TaC layer 122 covers the inner wall 113 of the matrix, the TaC layer 123 covers the lower surface 112, and the SiC layer 13 covers the outer wall 114 of the matrix.

It should be noted that FIG. 7A, FIG. 8A, and FIG. 9A merely describe three examples in which the SiC layer 13 is in contact with the TaC layer 12. In an actual application procedure, the SiC layer 13 and the TaC layer 12 may be disposed in contact with each other, or may be spaced apart. That the SiC layer 13 and the TaC layer 12 are spaced apart means that the graphite matrix between the SiC layer 13 and the TaC layer 12 is exposed.

A size of the second region is not specifically limited in embodiments of this application, and the size of the second region may be set based on a requirement.

The graphite ring provided in this implementation may include the graphite matrix 11, the TaC layer 12, and the SiC layer 13. The TaC layer 12 and the SiC layer 13 can suppress the graphite matrix from generating a falling object, so that the graphite ring has a long use and replacement interval.

The TaC layers (122, 123) are disposed between the inner wall of the matrix and the SiC layer 13, to prevent the SiC crystal deposited on a surface of the SiC layer from extending in a direction of the inner wall of the matrix, and further alleviate a decrease in the aperture of the graphite ring 1, so that the graphite ring 1 has a long maintenance interval. Compared with a graphite ring in which all of a surface of a graphite matrix is covered with a TaC layer, the graphite ring provided in this implementation has better heat dissipation performance.

A thickness of the SiC layer 13 is not specifically limited in embodiments of this application, and the thickness of the SiC layer 13 may be set based on a requirement. For example, in a feasible implementation, the thickness of the SiC layer 13 may range from 0.1 µm to 1000 µm. For example, the thickness of the SiC layer 13 may be 0.1 µm, 1 µm, 10 µm, 100 µm, or 1000 µm.

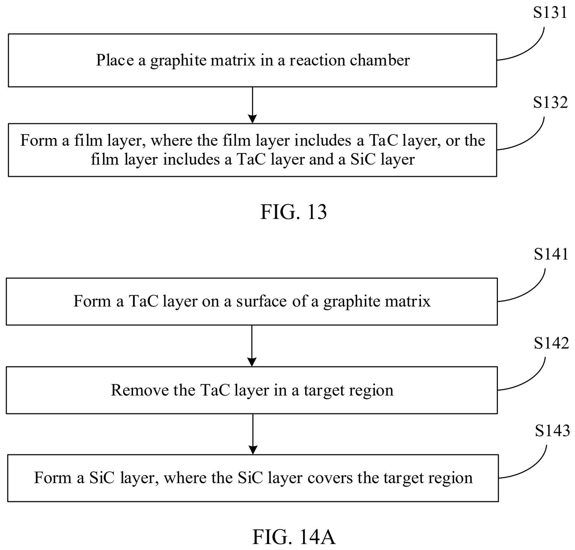

An embodiment of this application further provides a preparation method for a graphite ring. For details, refer to FIG. 13. FIG. 13 is a flowchart of a preparation method for a graphite ring provided in a feasible embodiment. It can be seen that the preparation method may include S131 and S132.

S131: Place a graphite matrix in a reaction chamber.

In this embodiment of this application, a reaction place at which a film layer (the film layer may include a SiC layer and a TaC layer, or the film layer may include a SiC layer) is formed on a surface of the graphite matrix is referred to as the reaction chamber.

The surface of the graphite matrix may include the upper surface, the lower surface, the inner wall of the matrix, and the outer wall of the matrix.

In a feasible implementation, the graphite matrix may be an existing graphite matrix.

In a feasible implementation, the graphite matrix may be prepared before the graphite matrix is placed in the reaction chamber. A common graphite matrix preparation method in this field may be used. For example, a graphite column may be made of an isostatically pressed graphite material, and then, a graphite matrix with an annular structure is formed by mechanically cutting/polishing the graphite column.

A size of the graphite matrix is not specifically limited in embodiments of this application. The size of the graphite matrix may include a size of an outer diameter of the graphite ring and a size of an inner diameter of the graphite ring.

In a feasible implementation, a size of an inner diameter of the graphite matrix may be designed based on a size of a substrate used in a subsequent epitaxial process, so that, in the epitaxial process, the substrate may be placed in a region limited by the inner wall of the matrix. For example, the size of the substrate may include 2 inches, 4 inches, 6 inches, 8 inches, and 10 inches.

In a feasible implementation, the size of the outer diameter of the graphite ring may be designed based on the reaction chamber used in the subsequent epitaxial process, so that, in the epitaxial process, the graphite matrix can be placed in the reaction chamber. The size of the reaction chamber may include 2 inches, 4 inches, 6 inches, 8 inches, and 10 inches.

S132: Form the film layer, where the film layer includes the TaC layer, or the film layer includes the TaC layer and the SiC layer.

The TaC layer covers the inner wall of the matrix. On the graphite matrix, a part or all of a surface other than the inner wall of the matrix is exposed, or a part or all of a surface other than the inner wall of the matrix is covered with a SiC layer.

A common method for forming the TaC layer in this field may be used. For example, the TaC layer may be formed by using CVD, a high-temperature sintering method, or an ion spraying method.

An implementation of forming the TaC layer is further described below by using an example in which the TaC layer is formed by using the CVD method.

In a feasible implementation, an implementation of the TaC layer may be as follows: The reaction chamber is heated, so that the reaction chamber can provide a temperature required for forming the TaC layer. A gas environment in the reaction chamber is a carbon source gas and a tantalum source gas. The carbon source gas can be decomposed into carbon atoms (C), and the tantalum source gas can be decomposed into tantalum atoms (Ta). C and Ta may be diffused and adsorbed to the surface of the graphite matrix. C and Ta adsorbed on the surface of the graphite matrix migrate toward each other, and are combined on the surface of the graphite matrix to form the TaC layer. The tantalum source gas may be tantalum pentachloride (TaCl₅) or tantalum tetrachloride (TaCl₄).

In a feasible implementation, an implementation of the TaC layer may be as follows: The reaction chamber is heated, so that the reaction chamber can provide a temperature required for forming the TaC layer. A gas environment in the reaction chamber is a tantalum source gas. Ta decomposed from the tantalum source gas may reach the surface of the graphite matrix, and is combined with C provided by the graphite matrix to form the TaC layer. The TaC layer obtained in this implementation is tightly nested in the graphite matrix in an in-situ growth manner. This significantly increases a binding force between the TaC layer and the graphite matrix, and effectively prevents the TaC layer from being peeled off.

In a feasible implementation, an implementation of the TaC layer may be as follows: The reaction chamber is heated, so that the reaction chamber can provide a temperature required for forming the TaC layer. A gas environment in the reaction chamber is tantalum vapor (Ta) and carbon vapor (C). Ta and C may be combined on the surface of the graphite matrix to form the TaC layer.

TaC has a low thermal conductivity, and correspondingly, the TaC layer prepared from TaC has poor heat dissipation performance. In the graphite ring, a larger area of the TaC layer indicates poorer heat dissipation performance of the graphite ring. To improve heat dissipation performance of the graphite ring, in this embodiment of this application, the TaC layer on a part/all of a surface of the outer wall of the matrix needs to be removed.

In a specific implementation, the TaC layer on a part/all of a surface other than the inner wall of the matrix (the upper surface, the lower surface, or the outer wall of the matrix) may be removed through mechanical processing or polishing. For a structure of the graphite ring that is finally prepared by removing the TaC layer on all of the surface other than the inner wall of the matrix, refer to FIG. 4. For a structure of the graphite ring that is finally prepared by removing the TaC layer on a part of the surface of the outer wall of the matrix, refer to FIG. 6A.

The exposed graphite matrix is likely to generate a falling object. To reduce generation of the falling object from the graphite matrix, in a feasible implementation, the graphite ring may include the graphite matrix and a composite film layer covering the graphite matrix. The composite film layer includes the TaC layer and the SiC layer.

The following describes, with reference to specific accompanying drawings, a preparation method for a graphite ring including a composite film layer.

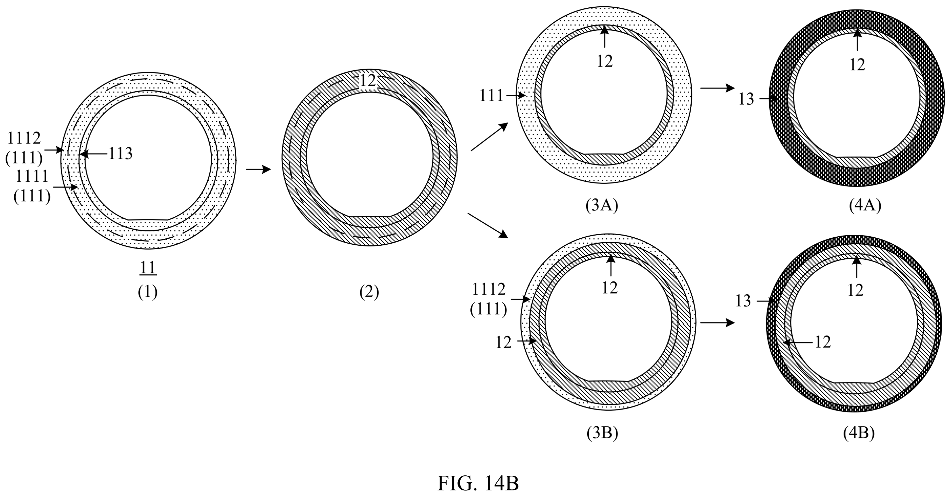

An embodiment of this application further provides a preparation method for a graphite ring. The graphite ring includes a composite film layer. Refer to FIG. 14A and FIG. 14B. FIG. 14A is a flowchart of the preparation method for the graphite ring provided in a feasible embodiment, and FIG. 14B is a process flowchart corresponding to the preparation method provided in FIG. 14A. The preparation method may include S141 to S143.

S141: Form a TaC layer on a surface of a graphite matrix.

For an implementation of forming the TaC layer on the surface of the graphite matrix, refer to the foregoing embodiment. Details are not described herein again.

(1) inFIG. 14B is a diagram of a graphite matrix. A surface of the graphite matrix may include an upper surface 111, a lower surface (not marked in the figure), an inner wall 113 of the matrix, and an outer wall of the matrix (not marked in the figure).

(2) in FIG. 14B is a diagram of a graphite matrix covered with a TaC layer on a surface. It can be seen that the TaC layer 12 covers the surface of the graphite matrix.

S142: Remove the TaC layer in a target region.

In this implementation, the target region includes the outer wall of the matrix, or the target region includes the outer wall of the matrix and a fourth region, where the fourth region includes a second region of the upper surface and/or a second region of the lower surface, and the second region is a region bordering the outer wall of the matrix.

A common TaC layer removing method in this field may be used. For example, the TaC layer in the target region may be removed through polishing.

For a structure obtained by removing the TaC layer on the outer wall of the matrix, the upper surface, and the lower surface, refer to (3A) in FIG. 14B. It can be seen that the upper surface 111, the lower surface, and the outer wall of the matrix are exposed.

For a structure obtained by removing the TaC layer on the second region of the upper surface, the outer wall of the matrix, and the second region of the lower surface, refer to (3B) in FIG. 14B. It can be seen that the second region 1112 of the upper surface, the outer wall of the matrix, and the second region of the lower surface are exposed.

S143: Form a SiC layer, where the SiC layer covers the target region.

A common implementation of forming the SiC layer in this field may be used. The SiC layer may be formed by using CVD, a high-temperature sintering method, an ion spraying method, or the like. Because no SiC layer is formed on a surface of the TaC layer, and the SiC layer may be formed on a surface of the exposed graphite matrix, the SiC layer may be formed in the target region in the solution provided in this implementation.

Based on the structure provided in (3A) in FIG. 14B, for a structure of the graphite ring obtained by forming the SiC layer, refer to (4A) in FIG. 14B. It can be seen that the graphite ring may include the graphite matrix 11, the SiC layer 13, and the TaC layer 12. The graphite matrix includes the upper surface 111, the lower surface, the inner wall 113 of the matrix, and the outer wall of the matrix. The TaC layer 12 covers the inner wall 113 of the matrix; and the SiC layer 13 covers the outer wall of the matrix, the upper surface 111, and the lower surface.

Based on the structure provided in (3B) in FIG. 14B, for a structure of the graphite ring obtained by forming the SiC layer, refer to (4B) in FIG. 14B. It can be seen that the graphite ring may include the graphite matrix 11, the SiC layer 13, and the TaC layer 12. The graphite matrix includes the upper surface 111, the lower surface, the inner wall 113 of the matrix, and the outer wall of the matrix. The TaC layer 12 covers the inner wall 113 of the matrix, a first region 1111 of the upper surface, and a first region of the lower surface; and the SiC layer 13 covers the outer wall of the matrix, the second region 1112 of the upper surface, and the second region of the lower surface.

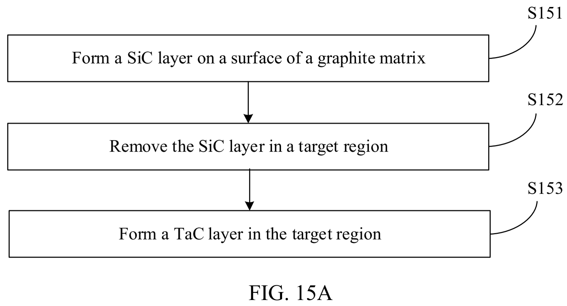

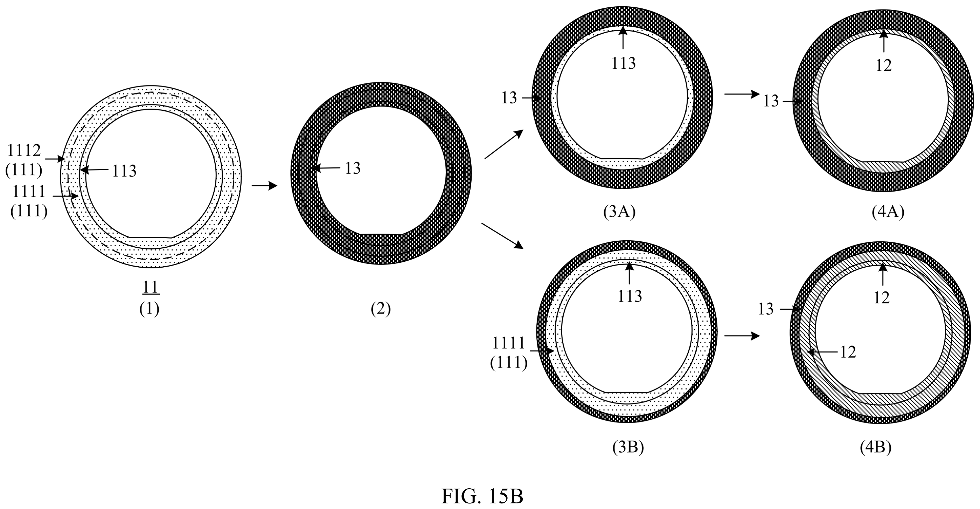

An embodiment of this application further provides a preparation method for a graphite ring including a composite film layer. Refer to FIG. 15A and FIG. 15B. FIG. 15A is a flowchart of the preparation method for the graphite ring provided in a feasible embodiment, and FIG. 15B is a process flowchart corresponding to the preparation method provided in FIG. 15A. The preparation method may include S151 to S153.

S151: Form a SiC layer on a surface of a graphite matrix.

For an implementation of forming the SiC layer, refer to the foregoing embodiment. Details are not described herein again.

(1) in FIG. 15B is a diagram of a graphite matrix. It can be seen that a surface of the graphite matrix may include an upper surface 111, a lower surface (not marked in the figure), an inner wall 113 of the matrix, and an outer wall of the matrix (not marked in the figure).

(2) in FIG. 15B is a diagram of a graphite matrix covered with a SiC layer on a surface. It can be seen that the SiC layer 13 covers the surface of the graphite matrix 11.

S152: Remove the SiC layer in a target region.

In this implementation, the target region includes the inner wall of the matrix, or the target region includes the inner wall of the matrix and a third region, where the third region includes a first region of the upper surface and/or a first region of the lower surface. The first region is a region bordering the inner wall of the matrix.

A common SiC layer removing method in this field may be used. For example, the SiC layer in the target region may be removed through polishing.

For a structure obtained by removing the SiC layer covering the inner wall of the matrix, refer to (3A) in FIG. 15B. It can be seen that the inner wall 113 of the matrix is exposed.

For a structure obtained by removing the SiC layer on the inner wall of the matrix and the third region, refer to (3B) in FIG. 15B. It can be seen that the inner wall 113 of the matrix, the first region 1111 of the upper surface, and the first region of the lower surface (not shown in the figure) are exposed.

S153: Form a TaC layer in the target region.

A part of an outer wall of the graphite matrix is covered with the SiC layer. In this embodiment of this application, the TaC layer needs to be formed in an exposed region of the graphite matrix. In this implementation, in a gas atmosphere of a tantalum source gas, and in an environment in which a reaction temperature is lower than a decomposition temperature of SiC, the TaC layer may be formed by Ta decomposed from the tantalum source gas and C on the exposed surface (the target region) of the graphite matrix, to avoid forming the TaC layer on a surface of the SiC layer. The TaC layer covers the inner wall of the matrix and the first region of the outer wall of the matrix. Because the reaction temperature is lower than the decomposition temperature of SiC, C cannot be decomposed from the SiC layer. Therefore, the TaC layer cannot be formed on the surface of the SiC layer in the gas atmosphere of the tantalum source gas.

Based on a structure provided in (3A) in FIG. 15B, for a structure of the graphite ring obtained by forming the SiC layer, refer to (4A) in FIG. 15B. It can be seen that the graphite ring may include the graphite matrix 11, the TaC layer 12, and the SiC layer 13. The graphite matrix may include the upper surface 111, the lower surface, the inner wall 113 of the matrix, and the outer wall of the matrix. The TaC layer 12 covers the inner wall 113 of the matrix; and the SiC layer 13 covers the outer wall of the matrix, the upper surface 111, and the lower surface.

Based on a structure provided in (3B) in FIG. 15B, for a structure of the graphite ring obtained by forming the SiC layer, refer to (4B) in FIG. 15B. It can be seen that the graphite ring may include the graphite matrix 11, the SiC layer 13, and the TaC layer 12. The graphite matrix includes the upper surface 111, the lower surface, the inner wall 113 of the matrix, and the outer wall of the matrix. The TaC layer 12 covers the inner wall 113 of the matrix, the first region 1111 of the upper surface, and the first region of the lower surface; and the SiC layer 13 covers the outer wall of the matrix, a second region 1112 of the upper surface, and a second region of the lower surface.

The graphite ring prepared by using the preparation method provided in this embodiment of this application may include the graphite matrix and the TaC layer. The TaC layer covers the inner wall of the matrix, and the TaC layer can protect the inner wall of the matrix, to suppress the inner wall of the matrix from generating a falling object, so that the graphite ring has a long replacement interval.

The TaC layer can hinder deposition of SiC. In an epitaxial process, an increase in a thickness of the TaC layer per unit time is small. Therefore, the graphite ring has a long maintenance interval.

The graphite ring prepared in this embodiment of this application has the long replacement interval and maintenance interval. Therefore, the graphite ring prepared in this embodiment of this application has low consumption costs. In addition, the graphite ring prepared in this embodiment of this application has the long replacement interval and maintenance interval. When the graphite ring provided in this embodiment of this application is used in the epitaxial process, a problem of a sudden change in doping concentration of an epitaxial layer caused by replacement/maintenance of the graphite ring in the epitaxial process can be reduced, and difficulty in adjusting and controlling the doping concentration of the epitaxial layer in the epitaxial process is low.

Compared with a graphite ring in which all of a surface of a graphite matrix is covered with a TaC layer, in the graphite ring prepared in this embodiment of this application, on the graphite matrix, a part or all of a surface other than the inner wall of the matrix are exposed or covered with the SiC layer. In this way, the graphite ring has better heat dissipation performance.

An embodiment of this application provides an epitaxial device, including an epitaxial reactor and the graphite ring provided in this embodiment of this application. The graphite ring is disposed in the epitaxial reactor.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A graphite ring, used in a SiC epitaxial process, wherein the graphite ring comprises a graphite matrix and a TaC layer;
the graphite matrix is an annular structural component, and a surface of the graphite matrix comprises an annular upper surface, an annular lower surface, an inner wall that is of the matrix and that is enclosed between inner diameters of the upper surface and the lower surface, and an outer wall that is of the matrix and that is enclosed between outer diameters of the upper surface and the lower surface;
the TaC layer covers the inner wall of the matrix; and
on the graphite matrix, at least a part of a surface other than the inner wall of the matrix is exposed or covered with a SiC layer.

2. The graphite ring according to claim 1, wherein on the graphite matrix, all of the surface other than the inner wall of the matrix is exposed.

3. The graphite ring according to claim 1, wherein on the graphite matrix, all of the surface other than the inner wall of the matrix is covered with the SiC layer.

4. The graphite ring according to claim 1, wherein the TaC layer further covers a first region of the upper surface, and the first region of the upper surface is a region bordering the inner wall of the matrix;
and/or
the TaC layer further covers a first region of the lower surface, and the first region of the lower surface is a region bordering the inner wall of the matrix.

5. The graphite ring according to any one of claims 1 to 4, wherein the SiC layer covers the outer wall of the matrix.

6. The graphite ring according to any one of claims 1 to 5, wherein the SiC layer covers a second region of the upper surface, and the second region of the upper surface is a region bordering the outer wall of the matrix;
and/or
the SiC layer further covers a second region of the lower surface, and the second region of the lower surface is a region bordering the outer wall of the matrix.

7. The graphite ring according to any one of claims 1 to 6, wherein a thickness of the TaC layer ranges from 0.1 µm to 1000 µm.

8. The graphite ring according to any one of claims 1 to 7, wherein a thickness of the SiC layer ranges from 0.1 µm to 1000 µm.

9. The graphite ring according to any one of claims 1 to 8, wherein the inner wall of the matrix comprises at least one annular surface sequentially connected between the upper surface and the lower surface.

10. The graphite ring according to claim 9, wherein the at least one annular surface comprises a first flow guiding surface, a limiting surface, and a second flow guiding surface, wherein the first flow guiding surface is obliquely disposed, and the second flow guiding surface is obliquely disposed.

11. A preparation method for a graphite ring, comprising:
placing a graphite matrix in a reaction chamber, wherein the graphite matrix is an annular structural component, and a surface of the graphite matrix comprises an annular upper surface, an annular lower surface, an inner wall that is of the matrix and that is enclosed between inner diameters of the upper surface and the lower surface, and an outer wall that is of the matrix and that is enclosed between outer diameters of the upper surface and the lower surface; and
forming a film layer, wherein the film layer comprises a TaC layer, or the film layer comprises a TaC layer and a SiC layer, wherein the TaC layer covers the inner wall of the matrix, and on the graphite matrix, at least a part of a surface other than the inner wall of the matrix is exposed or covered with the SiC layer.

12. The preparation method according to claim 11, wherein the step of forming the film layer comprises:
forming the SiC layer on the surface of the graphite matrix, wherein the surface of the graphite matrix comprises the inner wall of the matrix, the outer wall of the matrix, the upper surface, and the lower surface;
removing the SiC layer in a target region, wherein the target region comprises the inner wall of the matrix, or the target region comprises the inner wall of the matrix and a third region, wherein the third region comprises a first region of the upper surface and/or a first region of the lower surface, and the first region is a region bordering the inner wall of the matrix; and
forming the TaC layer in the target region.

13. The preparation method according to claim 11, wherein the step of forming the film layer comprises:
forming the TaC layer on the surface of the graphite matrix, wherein the surface of the graphite matrix comprises the inner wall of the matrix, the outer wall of the matrix, the upper surface, and the lower surface; and
removing the TaC layer in a target region, wherein the target region comprises the outer wall of the matrix, or the target region comprises the outer wall of the matrix and a fourth region, wherein the fourth region comprises a second region of the upper surface and/or a second region of the lower surface, and the second region is a region bordering the outer wall of the matrix.

14. The preparation method according to claim 13, wherein after the step of removing the TaC layer in the target region, the preparation method further comprises:
forming the SiC layer, wherein the SiC layer covers the target region.

15. An epitaxial device, comprising an epitaxial reactor and the graphite ring according to any one of claims 1 to 10, wherein the graphite ring is disposed in the epitaxial reactor.
